# EUROPEAN PATENT SPECIFICATION

(11) **EP 2 107 138 B1**
(45) Date of publication and mention of the grant of the patent: **18.01.2012**
(21) Application number: 09003062.8
(22) Date of filing: 03.03.2009
(51) Int. Cl.: C30B 25/02, C30B 29/36, C30B 25/16

(54) **Apparatus for producing silicon carbide single crystal**
Vorrichtung zur Herstellung von Siliciumcarbid-Einkristallen
Appareil pour la production de monocristal de carbure de silicium

(30) Priority: 05.03.2008 JP 2008055083
(43) Date of publication of application: 07.10.2009
(73) Proprietor: DENSO CORPORATION, Kariya-city, Aichi-pref. 448-8661 (JP)
(72) Inventor: Hara, Kazukuni, Aichi-pref, 448-8661 (JP)
(74) Representative: Winter, Brandl, Fürniss, Hübner, Röss, Kaiser, Polte - Partnerschaft

(56) References cited:
- EP-A1- 1 471 168
- WO-A1-2006/125777
- WO-A2-2008/146126

## Description

The present invention relates to an apparatus for producing a silicon carbide single crystal.

A silicon carbide (SiC) single crystal has a high breakdown voltage and a high electron mobility. Thus, the SiC single crystal is expected to be useful for a semiconductor substrate of a power device. The SiC single crystal can be produced by a high temperature chemical vapor deposition method (high temperature CVD method) as described, for example, in U. S. Patent No. 6,030,661 (corresponding to JP-A-11-508531). In the high temperature CVD method, the SiC single crystal is produced by an epitaxial growth of SiC at a high temperature.

In the method disclosed in U. S. Patent No. 6,030,661, mixed gas supplied from a gas introducing pipe flows into a susceptor through a passage made of a heat insulating material. When the mixed gas flows from the heat-insulated passage into the susceptor, the mixed gas is rapidly heated. Thus, it is difficult to produce a high quality SiC single crystal.

For restricting the rapid temperature increase of the mixed gas, the mixed gas may be heated at the passage for increasing the temperature of the mixed gas that flows into the susceptor. However, when the temperature of the mixed gas is higher than about 500 degrees centigrade, silicon (Si) may deposit on a wall of the passage. In addition, when the temperature of the mixed gas reach a reaction temperature of Si and carbon (C), Si reacts with C and SiC may deposit on the wall of the passage. As a result, the passage may clog with the deposits.

In an apparatus for producing an SiC single crystal disclosed in US 2004/231583 A (corresponding to JP-A-2002-154899), a cooling mechanism is provided in the vicinity of a gas introducing pipe for introducing mixed gas into a crucible. The cooling mechanism provides a temperature gradient so that temperature increases toward the crucible.

When the cooler is provided, the gas introducing pipe can be cooled effectively. However, if the cooler is damaged and cooling water leaking from the cooler enters the crucible, a pressure in the apparatus rapidly increases due to evaporation of the cooling water, and thereby the apparatus may be damaged.

According to a further prior art, document WO 2006/125777 A1 describes a device for introducing reaction gases into a reaction chamber of an epitaxial reactor, wherein the device comprises a gas supply pipe and a cooling member situated at one end of the supply pipe and cooling the supply pipe and thereby the gas flowing inside it.

Document WO 2008/ 146126 A2 discloses a reactor for growing crystals of a compound material, comprising: a cylindrical reaction chamber arranged in a manner such that the cylinder axis is vertical and being provided with walls, the inner surfaces of which define at least partly an inner cavity of the chamber, means for heating the reaction chamber; wherein the reaction chamber comprises inlet means for feeding several precursor gases of the compound material into the cavity, which are located in the lower zone of the chamber, an assembly holding at its bottom a seed or a substrate on which the growth takes place and located in the upper zone of the chamber, so that at least the seed or substrate and the growing crystal are kept within the cavity, outlet means for discharging exhaust gases from the cavity, which are arranged around the assembly in the upper zone of the chamber; wherein the inlet means comprises an opening obtained in a bottom wall of the chamber, an injector device arranged outside the cavity and injecting at least a first and a second precursor gas of the compound material simultaneously into the cavity through the opening; and wherein the injector device keeps the two precursor gases cold and separate from each other until injection takes place.

In view of the foregoing problems, it is an object of the present invention to provide an apparatus for producing an SiC single crystal.

According to the present invention, an apparatus for producing an SiC single crystal includes a vacuum chamber, a reaction container, a gas introducing pipe, and a cooler. The reaction container is disposed in the vacuum chamber and defines an internal space where an SiC single crystal substrate is disposed as a seed crystal. The reaction container has an opening portion through which the internal space of the reaction container communicates with a portion of an internal space of the vacuum chamber located below the reaction container. The gas introducing pipe connects an outside of the vacuum chamber and an inside of the vacuum chamber for supplying a mixed gas from the outside of the vacuum chamber to the SiC single crystal substrate through the opening portion of the reaction container. The mixed gas includes a silicon-including gas and a carbon-including gas. The cooler is disposed adjacent to the gas introducing pipe and is apart from the reaction container. The cooler is outside a supply passage of the mixed gas provided from the gas introducing pipe to the SiC single crystal substrate located above the gas introducing pipe. The cooler is configured to reduce a surrounding temperature by fluid flowing in the cooler. At least a portion of the cooler is located below the reaction container. The cooler includes a wall having a first section facing the internal space of the reaction container and a second section other than the first section. The first section has a first mechanical strength and the second section has a second mechanical strength. The first mechanical strength is greater than the second mechanical strength.

In the present apparatus, the first section of the wall of the cooler facing the internal space of the reaction container has the mechanical strength greater than the mechanical strength of the second section other than the first section. Thus, even if the cooler is damaged, the fluid is restricted from scattering in the internal space of the reaction container, and thereby a rapid pressure increase in the vacuum chamber can be restricted.

Additional objects and advantages of the present invention will be more readily apparent from the following detailed description of preferred embodiments when taken together with the accompanying drawings. In the drawings:
FIG. 1 is a diagram illustrating a cross-sectional view of an apparatus for producing an SiC single crystal according to a first embodiment
FIG. 2 is a diagram illustrating an enlarged view of a part of the apparatus including a shielding plate and a cooler;
FIG. 3 is a diagram illustrating a cross-sectional view of the cooler taken along line III-III in FIG. 2;
FIG. 4 is a flowchart illustrating an exemplary process for reducing a leakage of cooling water;
FIG. 5 is a diagram illustrating an enlarged view of a part of an apparatus for producing an SiC single crystal according to a modification of the first embodiment;
FIG. 6 is a diagram illustrating an enlarged view of a part of an apparatus for producing an SiC single crystal according to a second embodiment and
FIG. 7 is a diagram illustrating an enlarged view of a part of an apparatus for producing an SiC single crystal according to the present invention.

### (First Embodiment)

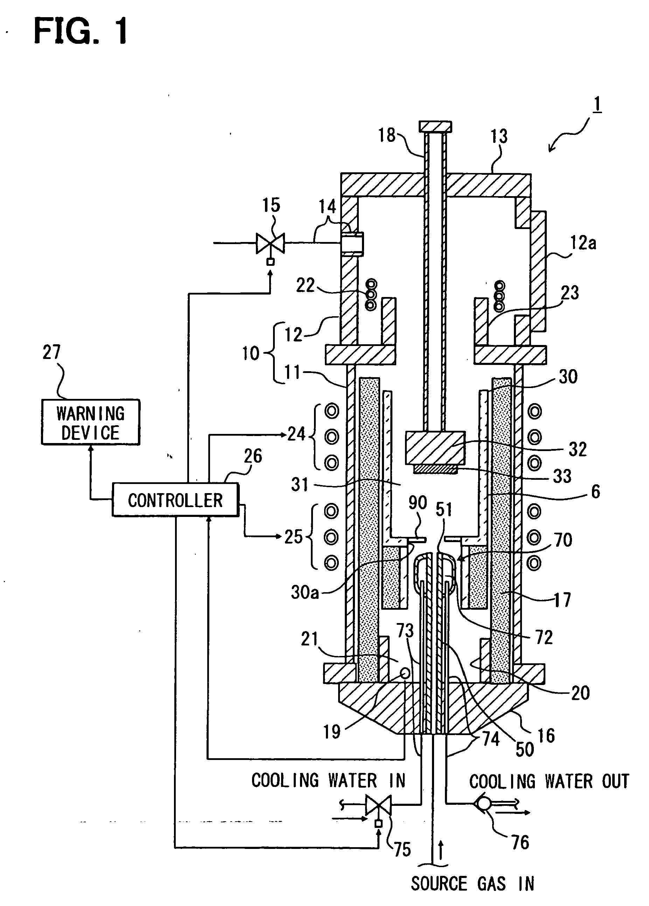

An apparatus 1 for producing an SiC single crystal according to a first embodiment will be described with reference to FIG. 1 to FIG. 3. The apparatus 1 includes a vacuum chamber 10, a crucible 30, a gas introducing pipe 50, a cooler 70, and a shielding plate 90. The crucible 30 is disposed in the vacuum chamber 10. The crucible 30 can function as a reaction container. The crucible 30 has a through hole 30a. In the following description, an extending direction of the through hole 30a is defined as a vertical direction, and a direction perpendicular to the vertical direction is defined as a horizontal direction. The gas introducing pipe 50 introduces source gas into the crucible 30. The cooler 70 cools the gas introducing pipe 50 for providing a temperature gradient. The shielding plate 90 blocks cooling water leaking from the cooler 70.

The vacuum chamber 10 has an approximately cylindrical shape and defines an internal space. The vacuum chamber 10 has a lower chamber 11 and an upper chamber 12. The lower chamber 11 is a portion to hold the crucible 30. The upper chamber 12 is a portion to take out a completed SiC.

The upper chamber 12 is made of SUS (stainless steel), for example. The upper chamber 12 has a take-out port 12a on a sidewall thereof. The take-out port 12a is provided for taking out an SiC single crystal that grows in the vacuum chamber 10. The upper chamber 12 has an upper opening portion. The upper opening portion is covered with a top flange 13. The top flange 13 is made of SUS, for example. An exhaust pipe 14 is coupled with a portion of the upper chamber 12 other than the take-out port 12a. The exhaust pipe 14 connects an outside of the vacuum chamber 10 and an inside of the vacuum chamber 10. The exhaust pipe 14 is coupled with a vacuum pump (not shown) through a pressure control valve 15 including an actuator. The pressure control valve 15 can function as a pressure control element. The vacuum chamber 10 is evacuated by the vacuum pump and the pressure control valve 15. Thus, a pressure in the vacuum chamber 10 is controlled by the vacuum pump and the pressure control valve 15.

The lower chamber 11 is made of quartz, for example. The lower chamber 11 has a lower opening portion. The lower opening portion is covered with a bottom flange 16. The bottom flange 16 is made of SUS, for example. The crucible 30 is disposed in the lower chamber 11 and is surrounded by a first heat insulating member 17.

The crucible 30 has an approximately cylindrical shape having a bottom. The crucible 30 opens at an upper portion thereof. The crucible 30 defines an internal space 31 surrounded by an upper end of the crucible 30, a sidewall of the crucible 30, and a bottom of the crucible 30 including the through hole 30a. Thus, the internal space 31 is also a portion of the internal space of the vacuum chamber 10. A pedestal 32 is located in the internal space 31 of the crucible 30 so as to be apart from the sidewall of the crucible 30. On a lower surface of the pedestal 32, an SiC single crystal substrate 33 as a seed crystal is attached. The internal space 31 of the crucible 30 provides a reaction room where the SiC single crystal grows on the SiC single crystal substrate 33.

The crucible 30 is made of, for example, a high purity graphite that can withstand temperature of about 2400 degree centigrade. When the crucible 30 is made of the high purity graphite, the amount of impurities generated from the heated crucible 30 can be restricted. Thus, the SiC single crystal that grows in the crucible 30 can be restricted from taking in the impurities.

The pedestal 32 is fixed at a lower end of a shaft 18 extending in the vertical direction. The shaft 18 is coupled with a rotating and vertically moving device (not shown). The rotating and vertical moving device can rotate and vertically move the shaft 18. That is, the rotating and vertical moving device can move the shaft 18 upward from a position illustrated in FIG. 1 so that the grown SiC moves to a take-out room defined by the upper chamber 12. In addition, the rotating and vertically moving device can move the SiC single crystal substrate 33 from the take-out room to the internal space 31 of the crucible 30. Furthermore, the rotating and vertically moving device can rotate the shaft 18 in a state where the SiC single crystal substrate 33 is located in the internal space 31 so that the SiC single crystal substrate 33 rotates and the SiC single crystal grows. The shaft 18 has a pipe shape, for example. The shaft 18 has a lower section made of quartz and an upper section made of SUS.

The through hole 30a is provided at an approximately center portion of the bottom of the crucible 30 and is surrounded by a peripheral portion of the bottom. A portion of the internal space of vacuum chamber 10 located below the crucible 30 is a low-temperature area. The internal space 31 of the crucible 30 communicates with the low-temperature area through the through hole 30a. The gas introducing pipe 50 connects the outside of the vacuum chamber 10 and the inside of the vacuum chamber 10. The gas introducing pipe 50 has an upper end portion 51 located below the crucible 30. The gas introducing pipe 50 supplies the source gas from the outside of the vacuum chamber to the SiC single crystal substrate 33 in the internal space 31 of the crucible 30. The source gas is a mixed gas including a silicon-including gas, a carbon-including gas, and at least one of hydrogen, helium, and argon. The silicon-including gas is monosilane gas, for example. The carbon-including gas is propane gas, for example.

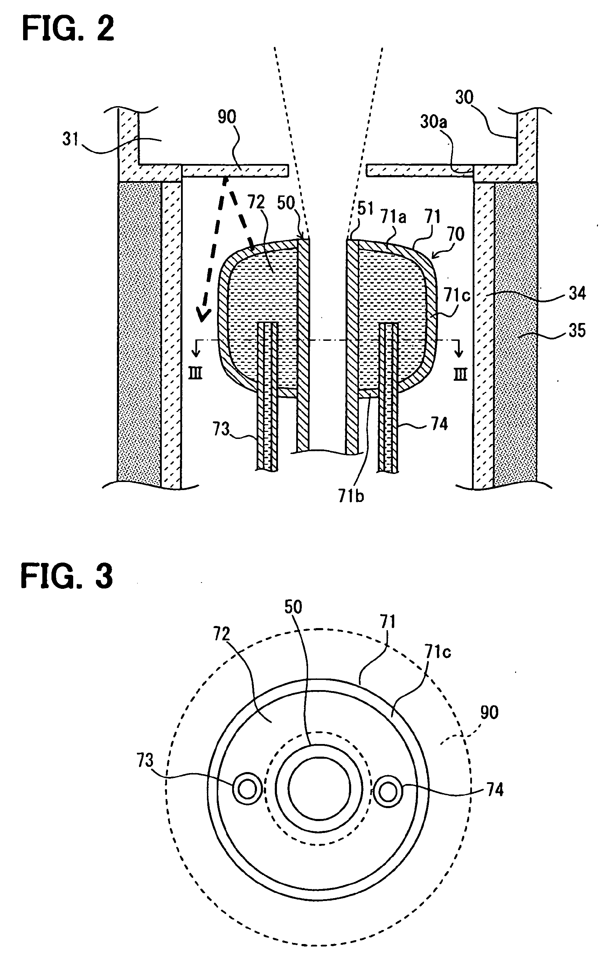

The gas introducing pipe 50 is apart from the crucible 30 and the cooler 70 is disposed adjacent to the gas introducing pipe 50. The crucible 30 is arranged so that the source gas can be supplied from the gas introducing pipe 50 to the SiC single crystal substrate 33 in the internal space 31 and cooling water leaking from the cooler 70 can drop below the internal space 31. In the present embodiment, the gas introducing pipe 50 is arranged in such a manner that the upper end portion 51 is located below the bottom of the crucible 30, as illustrated in FIG. 1 and FIG. 2. Thus, the gas introducing pipe 50 is located outside the internal space 31 of the crucible 30. The gas introducing pipe 50 is made of SUS, for example.

In the vacuum chamber 10, the cooler 70 is disposed adjacent to the gas introducing pipe 50. The cooler 70 reduces a surrounding temperature by circulating cooling water therein, and thereby the cooler 70 provides a predetermined temperature gradient to the gas introducing pipe 50. As a result, a different in temperature of the source gas between the gas introducing pipe 50 and the crucible 30 can be reduced and a clog of the gas introducing pipe 50 due to deposition of Si and SiC can be restricted. The temperature of gas introducing pipe 50 increases toward the crucible 30. The cooler 70 is apart from the crucible 30 so that a high temperature of the internal space 31 is maintained and a damage of the crucible 30 due to the difference in temperature is restricted. As illustrated in FIG. 2, the cooler 70 includes a body 71 having an approximately U-shape in cross section. The body 71 is made of SUS, for example. An upper end of the body 71 is joined at an upper end of a sidewall of the gas introducing pipe 50. A lower end of the body 71 is joined at a portion below the joint portion of the upper end of the body 71. The body 71 and the sidewall of the gas introducing pipe 50 define a storing space 72 therebetween. The cooling water circulates through the storing space 72. The body 71 of the cooler 70 and the gas introducing pipe 50 can function as a wall of the cooler 70. As illustrated in FIG 3, the cooler 70 has an approximately ring shape surrounding the gas introducing pipe 50. The body 71 has an upper section 71 a facing the crucible 30, a lower section 71 b facing the bottom flange 16, and a side section 71 c connecting the upper section 71 a and the lower section 71b. In an example illustrated in FIG. 3, the body 71 has a substantially uniform thickness at the upper section 71 a, the lower section 71 b, and the side section 71c. A thickness of the gas introducing pipe 50 in the horizontal direction is greater than the thickness of the body 71.

The cooler 70 is coupled with an inlet pipe 73 and an outlet pipe 74. Each of the inlet pipe 73 and the outlet pipe 74 penetrate through the lower section 71 b of the body 71. The inlet pipe 73 connecting the vacuum chamber 10 and the inside of the vacuum chamber 10. The inlet pipe 73 supplies the cooling water from an outside of the vacuum chamber 10 to the storing space 72 of the cooler 70. The outlet pipe 74 connecting the outside of the vacuum chamber 10 and the inside of the vacuum chamber 10. The outlet pipe 74 drains the cooling water from the storing space 72 of the cooler 70 to the outside of the vacuum chamber 10. As illustrated in FIG. 3, the inlet pipe 73 and the outlet pipe 74 are arranged on opposite sides of the gas introducing pipe 50. As illustrated in FIG. 1, the inlet pipe 73 is provided with a supply control valve 75 at the outside of the vacuum chamber 10. The supply control value 75 can function as a supply control element. The supply control valve 75 controls the amount of cooling water to be supplied to the storing space 72 of the cooler 70. The outlet pipe 74 is provided with a check valve 76 at the outside of the vacuum chamber 10. The check valve 76 prevents the cooling water from being drawn in an opposite direction of a drain direction.

A predetermined section of the gas introducing pipe 50 from the upper end portion 51 to a portion located below a lower end of the cooler 70 is surrounded by a second heat insulating member 35. On an inner surface of the second heat insulating member 35, a graphite layer 34 is disposed. Thus, at the predetermined section, the first heat insulating member 17 and the second heat insulating member 35 having the graphite layer 34 are located between the lower chamber 11 and the gas introducing pipe 50 integrated with the cooler 70. An upper end of the second heat insulating member 35 including the graphite layer 34 is coupled with the peripheral portion of the bottom of the crucible 30. Thus, a clearance is provided between the internal space 31 of the crucible 30 and a portion of internal space of the vacuum chamber 10 located below the second heat insulating member 35, that is, the low-temperature area. Thereby, heat at the crucible 30 is restricted from escaping below the second heat insulating member 35. If the cooler 70 is damaged and a leakage of the cooling water occurs, the cooling water drops to the portion of the internal space of the vacuum chamber 10 located below the second heat insulating member 35.

The shielding plate 90 is disposed between the cooler 70 and the internal space 31 of the crucible 30. The shielding plate 90 is outside a supply passage of the source gas provided from the gas introducing pipe 50 to the SiC single crystal substrate 33. The shielding plate 90 restricts the cooling water from scattering in the internal space 31 of the crucible 30 when the body 71 of the cooler 70 is damaged and a leakage of the cooling water occurs. The shielding plate 90 can function as a shielding part. The shielding plate 90 is made of a material that has a high thermal conductivity and a high thermal resistance. For example, the shielding plate 90 may be made of a carbon material, SiC, or molybdenum. The shielding plate 90 may be configured so that the cooling water being in contact with the shielding plate 90 is difficult to evaporate compared with a case where the cooling water is in contact with the crucible 30. For example, the shielding plate 90 may be made of a material having a specific heat lower than the crucible 30. The shielding plate 90 may also be made of a carbon porous material having a bulk density of about 1.0 g/cm³. As described above, the cooler 70 and the gas introducing pipe 50 are located below the crucible 30. The shielding plate 90 has a ring shape and is fixed to a wall of the through hole 30a provided at the bottom of the crucible 30. A thickness of the shielding plate 90 in the vertical direction is less than a thickness of the bottom of the crucible 30. The shielding plate 90 expands in the horizontal direction and is fixed to the wall of the through hole 30a, for example, by screwing. In the horizontal direction, a center of the shielding plate 90 having the ring shape is approximately corresponding to a center of the gas introducing pipe 50 and a center of the SiC single crystal substrate 33. As illustrated in FIG. 3, an internal circumference of the ring shape of the shielding plate 90 is located outside the gas introducing pipe 50 in the horizontal direction. The supply passage of the source gas is defined as an area connecting an opening provided at the upper end portion 51 of the gas introducing pipe 50 and horizontal ends of the SiC single crystal substrate 33, that is, an area between the dashed lines in FIG. 2.

As illustrated in FIG. 1, a temperature sensor 19 is disposed in the portion of the internal space of the vacuum chamber 10 located below the crucible 30. With a controller 26, the temperature sensor 19 can function as a leakage detecting element for detecting a leakage of the cooling water if the body 71 of the cooler 70 is damaged and the cooling water leaks. The temperature sensor 19 includes a thermocouple. On the bottom flange 16, a ring-shaped wall 20 is disposed. The ring-shaped wall 20 is made of, for example, SUS. The ring-shaped wall 20 and the bottom flange 16 provide a lower storing portion 21. The temperature sensor 19 is disposed in the lower storing portion 21 so as to be located just under the clearance between the cooler 70 and the second heat insulating member 35.

In a portion of the internal space of the vacuum chamber 10 located above the crucible 30, a cold trap 22 and an upper storing portion 23 are provided. If the body 71 of the cooler 70 is damaged and the leaking cooling water evaporates into vapor, the cold trap 22 traps and cools the evaporated water. The upper storing portion 23 stores water trapped by the cold trap 22. In the present embodiment, the upper storing portion 23 is disposed at a lower end portion of the upper chamber 12. The upper storing portion 23 has a predetermined depth. The cold trap 22 is disposed just over the upper storing portion 23.

An upper RF coil 24 is put around an outer peripheral portion of the vacuum chamber 10 at a height similar to the SiC single crystal substrate 33. When electricity is supplied to the upper RF coil 24, the upper RF coil 24 can heat the SiC single crystal substrate 33 during the growth of the SiC single crystal. Below the upper RF coil 24, a lower RF coil 25 is put around the outer peripheral portion of the vacuum chamber 10. When electricity is supplied to the lower RF coil 25, the lower RF coil 25 can heat a lower section of the crucible 30 and an upper section of the gas introducing pipe 50. Each of the upper RF coil 24 and the lower RF coil 25 is a high-frequency dielectric heating coil and can function as a heating element.

The controller 26 has a determining section and a control section. The determining section determines whether the cooling water leaks from the cooler 70 based on a detecting signal from the temperature sensor 19. The control section controls the actuators based on the determining result of the determining section. That is, the temperature sensor 19 and the determining section of the controller 26 can function as the leakage detecting element. The controller 26 is electrically coupled with the actuator for controlling an opening degree of the pressure control valve 15, an actuator for controlling outputs of the upper RF coil 24 and the lower RF coil 25, and the actuator for controlling an opening degree of the supply control valve 75. The control section of the controller 26 controls the actuators based on the determining result of the determining section. That is, the control section of the controller 26 include a first control part for controlling the supply amount of the cooling water, a second control part for controlling the outputs of the upper RF coil 24 and the lower RF coil 25, and a third control part for controlling the opening degree of the pressure control valve 15. The apparatus 1 further includes a warning device 27. The warning device 27 warns that a leakage of the cooling water occurs based on a leakage detecting signal from the controller 26.

An exemplary method of producing an SiC single crystal using the apparatus 1 will now be described. The SiC single crystal substrate 33 used as a seed crystal is attached to the lower surface of the pedestal 32. Then, the SiC single crystal substrate 33 is arranged at a predetermined portion in the internal space 31 of the crucible 30 by controlling the shaft 18. The vacuum chamber 10 is evacuated through the exhaust pipe 14. The upper RF coil 24 and the lower RF coil 25 are supplied with electricity so as to heat the SiC single crystal substrate 33, the crucible 30, and the upper section of the gas introducing pipe 50. The temperature of the crucible 30 is maintained at a predetermined temperature higher than 1420 degree centigrade that is the melting temperature of Si. For example, the temperature of the crucible 30 is maintained at a temperature about 2400 degree centigrade at which SiC is capable of sublimating. In addition, the pressure in the vacuum chamber 10 is set to be a predetermined pressure, for example, by introducing argon gas. Then, the source gas is introduced from the gas introducing pipe 50 to the internal space 31 of the crucible 30. Thereby, the SiC single crystal grows on the SiC single crystal substrate 33.

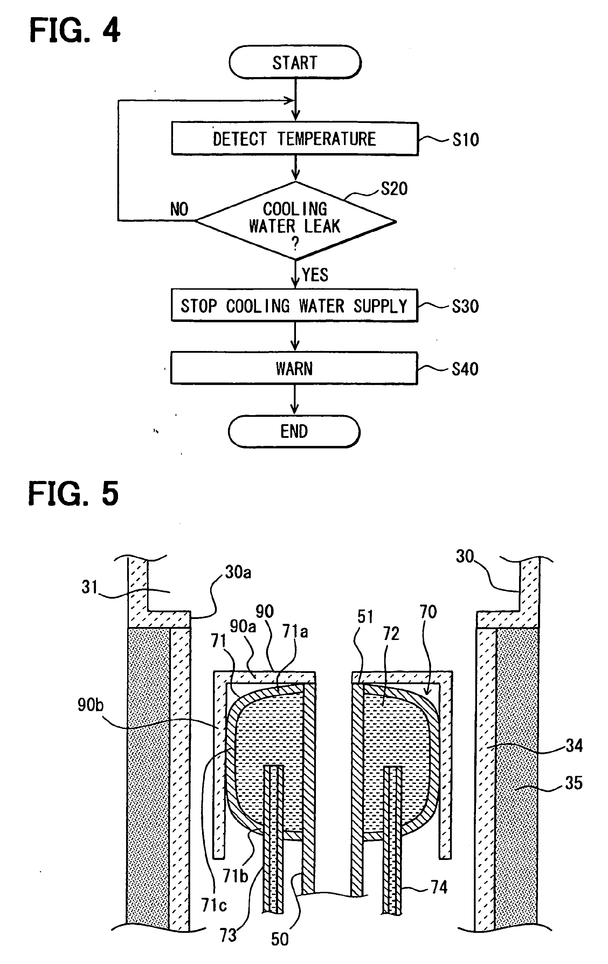

As an example of a control by the controller 26, an exemplary method of controlling the supply control valve 75 will be described with reference to FIG. 4.

When a production of the SiC single crystal starts, that is, when the source gas is introduced from the gas introducing pipe 50 to the internal space 31 of the crucible 30, the temperature sensor 19 starts to detect temperature and outputs the detecting signal to the controller 26 at S10.

At S20, the determining section of the controller 26 determines whether the cooling water leaks from the cooler 70 based on the detecting signal from the temperature sensor 19, for example, by comparing the detecting signal with a threshold value. If the determining section of the controller 26 determines that the cooling water does not leak from the cooler 70, the process at S10 and S20 is repeated and the production of the SiC single crystal continues.

If the determining section of the controller 26 determines that the cooling water leaks from the cooler 70, the control section of the controller 26 outputs a signal to the actuator for controlling the opening degree of the supply control valve 75 provided at the inlet pipe 73 of the cooling water. Thereby, the supply control valve 75 is closed, and the supply of the cooling water to the storing space 72 of the cooler 70 is stopped at S30.

At S40, the controller 26 outputs the signal to the warning device 27 so as to inform that a leakage of the cooling water occurs. Then, the warning device 27 warns that a leakage of the cooling water occurs, for example, by using a buzzer or a warning light. Furthermore, the production of the SiC single crystal is stopped.

In FIG. 4, the exemplary method of controlling the opening degree of the supply control valve 75 based on the determination of whether a leakage of the cooling water occurs is illustrated as an example. The opening degree of the pressure control valve 15, the outputs of the upper RF coil 24 and the lower RF coil 25 can be controlled in a manner similar to the above-described method. When the determining section of the controller 26 determines that a leakage of the cooling water occurs at S20, the control section of the controller 26 outputs a signal to the actuator of the pressure control valve 15 provided at the exhaust pipe 14 so that the opening degree of the pressure control valve 15 becomes a fully open state and gas in the vacuum chamber 10 is exhausted to the outside of the vacuum chamber 10. In addition, the control section of the controller 26 outputs a signal to the actuator of the upper RF coil 24 and the lower RF coil 25 so that the outputs of the upper RF coil 24 and the lower RF coil 25 are reduced or stopped.

In the apparatus 1 according to the present embodiment, the water-cooling type cooler 70 is arranged adjacent to the upper end portion of the gas introducing pipe located below the crucible 30. The shielding plate 90 extending to the horizontal direction is fixed to the wall of the through hole 30a provided at the bottom of the crucible 30 so that the shielding plate 90 does not disturb the supply of the source gas to the SiC single crystal substrate 33. Thus, even if the cooler 70 for cooling the gas introducing pipe 50 is damaged and leaking cooling water scatters above the cooler 70, the scattering cooling water is reflected by the shielding plate 90 as illustrated by the dashed arrow in FIG. 2. The temperature of the shielding plate 90 is lower than the temperature of the crucible 30. The cooling water drops to the lower storing portion 21 through the clearance between the cooler 70 and the second heat insulating member 35 having the graphite layer 34. The lower storing portion 21 is provided at the low-temperature area in the vacuum chamber 10 located below the crucible 30. In this way, the apparatus 1 can restrict the cooling water from scattering into the internal space 31 of the crucible 30 located in the high-temperature area above the cooler 70. Thus, the cooling water leaking from the cooler 70 does not scatter into the internal space 31 of the crucible 30, and a rapid pressure increase in the vacuum chamber 10 due to evaporation of the cooling water can be reduced.

The shielding plate 90 is located above the cooler 70. However, the shielding plate 90 has the ring shape and the inner circumference is larger than the upper end portion 51 of the gas introducing pipe 50 so that the shielding plate 90 does not disturb the supply of the source gas. Thus, the source gas can be supplied from the gas introducing pipe 50 to the SiC single crystal substrate 33 located in the internal space 31 of the crucible 30.

The gas introducing pipe 50 and the cooler 70 is located below the crucible 30. Thereby, a facing area of the cooler 70 and the internal space 31 of the crucible 30 except for the supply passage of the source gas is reduced. Thus, the scattering of the cooling water into the internal space 31 of the crucible 30 can be restricted by providing the shielding plate 90 only above the cooler 70. Therefore, an area of the shielding plate 90 can be reduced and a configuration of the shielding plate 90 can be simplified.

Even if the cooler 70 is damaged, a leakage of the cooling water can be detected by the temperature sensor 19 and the controller 26. When the controller 26 detects a leakage of the cooling water, the controller 26 outputs the signal to the actuator of the supply control valve 75 provided at the inlet pipe 73 so that the supply of the cooling water to the cooler 70 is stopped. Thereby, the amount of the cooling water leaking from the cooler 70, that is, the amount of cooling water to be evaporated can be reduced. As a result, a rapid pressure increase in the vacuum chamber 10 can be restricted.

In addition, when the controller 26 detects a leakage of the cooling water, the controller 26 controls the actuator for controlling the outputs of the upper RF coil 24 and the lower RF coil 25 so that the outputs of the upper RF coil 24 and the lower RF coil 25 are reduced or stopped. Thereby, the evaporation of the leaking cooling water can be restricted and a rapid pressure increase in the vacuum chamber 10 can be restricted.

Furthermore, when the controller 26 detects a leakage of the cooling water, the controller 26 controls the actuator of the pressure control valve 15 provided at the exhaust pipe 14 so that gas in the vacuum chamber 10 is exhausted to the outside of the vacuum chamber 10. Thereby, the pressure in the vacuum chamber 10 can be reduced and a rapid pressure increase in the vacuum chamber 10 can be restricted.
The outlet pipe 74 coupled with the cooler 70 is provided with the check valve 76 at a portion located outside the vacuum chamber 10. Thus, the outlet pipe 74 drains the cooling water from the storing space 72 of the cooler 70 to the outside of the vacuum chamber 10 and a suction of fluid from the outlet pipe 74 can be restricted. The supply of the cooling water to the cooler 70 is stopped by fully closing the supply control valve 75. Even if the storing space 72 of the cooler 70 becomes empty, fluid, for example, air is not suctioned from the outlet pipe 74 to the storing space 72 of the cooler 70. Thereby, the apparatus 1 can prevent the possibility that the suctioned air leaks from the cooler 70, the leaking air reacts with the source gas in the internal space 31 of the crucible 30, and the apparatus 1 is damaged due to a heat generation and or a volume expansively.

The cold trap 22 and the upper storing portion 23 are provided between the crucible 30 and the exhaust pipe 14. Even if the cooler 70 is damaged, the cooling water evaporated in the internal space 31 of the crucible 30 is changed into water at the cold trap 22 and is stored at the upper storing portion 23. Thus, the rapid pressure increase due to the evaporation of the cooling water can be restricted.

In the apparatus 1 illustrated in FIG. 1, the gas introducing pipe 50 and the cooler 70 are located below the crucible 30, and the shielding plate 90 is fixed at the bottom of the crucible 30, as an example. The location of the shielding plate 90 is not limited to the above-described example. For example, the shielding plate 90 may be fixed to the gas introducing pipe 50 or the cooler 70. In an apparatus according to a modification of the first embodiment, the shielding plate 90 is made of a porous material such as graphite and has an inverted L shape in cross section, as illustrated in FIG. 5. The shielding plate 90 has a short section 90a and a long section 90b. The shielding plate 90 is fixed, for example, by screwing, in such a manner that the short section 90a facing the upper section 71 a of the body 71 of the cooler 70 is in contact with the upper end portion 51 of the gas introducing pipe 50 and a part of the upper section 71 a of the body 71, and the long section 90b is in contact with the side section 71c of the body 71. An opening portion of the short section 90a corresponds to the opening portion of the gas introducing pipe 50. A lower end of the long section 90b is located below the lower section 71 b of the body 71. In the present case, the cooling water leaking from the cooler 70 sinks in the shielding plate 90, and then the cooling water drops downward. Thus, the scattering of the cooling water reflected by the shielding plate 90 can be restricted. Because the cooling water sinks in the shielding plate 90, the cooling water can escape downward even through a clearance is not provided between the cooler 70 and the shielding plate 90. In addition, because the leaking cooling water can escape to only lower side of the cooler 70, the scattering of the cooling water into the internal space 31 of the crucible 30 can be effectively restricted. Furthermore, the shielding plate 90 made of the porous material has a high heat insulation. Thus, a heat damage of the body 71 of the cooler 70 can be reduced.

In the apparatus illustrated in FIG. 5, the shielding plate 90 made of the porous material is fixed so as to be in contact with the cooler 70. When the shielding plate 90 is made of a material in which the cooling water does not sink, that is, a material reflecting the cooling water, the long section 90b is separated from the side section 71 c of the body 71 so as to provide a clearance therebetween. In such a case, the cooling water leaking from the upper section 71 a of the body 71 can escape downward trough the clearance.

In the apparatus illustrated in FIG. 5, the shielding plate 90 made of the porous material has the inverted L shape in cross section. The shielding plate 90 made of the porous material may have other shape. For example, the shielding plate 90 having a flat plate shape as illustrated in FIG. 2 may be made of a porous material.

In the apparatus 1 according to the present embodiment, a leakage of the cooling water from the cooler 70 is detected using the temperature sensor 19 and the controller 26. If a leakage of the cooling water is detected, in accordance with the signals from the controller 26, the supply of the cooling water to the cooler 70 is stopped, the gas in the vacuum chamber 10 is exhausted, and the outputs of the upper RF coil 24 and the lower RF coil 25 are reduced or stopped. However, the apparatus 1 is required to include at least the shielding part, for example, configured by the shielding plate 90. The apparatus 1 may include at least one of the above-described three control parts.

In the apparatus 1 according to the present embodiment, the cooler 70 and the gas introducing pipe 50 are integrated. In the present case, the cooler 70 can effectively cool the gas introducing pipe 50 and can provide the predetermined temperature gradient. Alternatively, the cooler 70 may be separated from the gas introducing pipe 50. Also in such a case, the shielding part, for example, configured by the shielding plate 90 is disposed in such a manner that the shielding part is outside the supply passage of the source gas, and the shielding part restricts the cooling water from scattering into the internal space 31 of the crucible 30 and drops the cooling water below the internal space 31.

### (Second Embodiment)

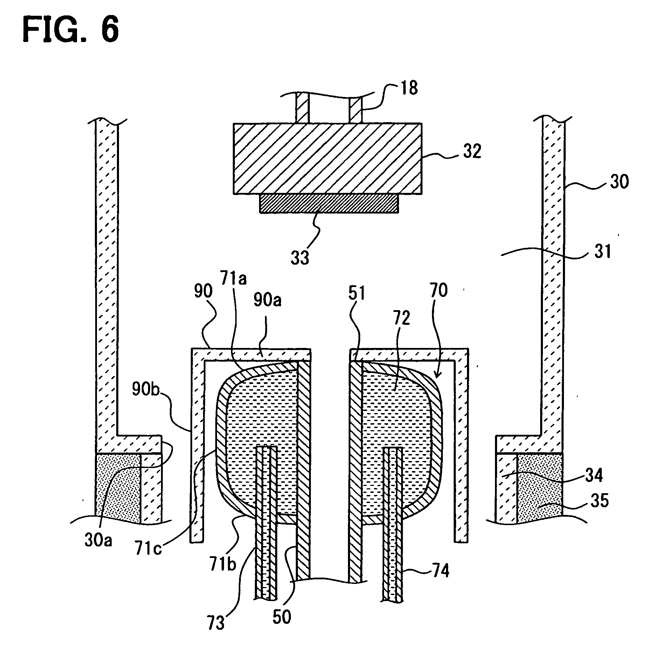

An apparatus 1 for producing an SiC single crystal according to a second embodiment will be described with reference to FIG. 6. Because the apparatus 1 according to the present embodiment has many portions in common with the apparatus 1 according to the first embodiment, a description of the common portions will be omitted and different portions will be mainly described.

In the apparatus 1 according to the present embodiment, a portion of the cooler 70 is located in the internal space 31 of the crucible 30, that is, above an outer surface of the bottom of the crucible 30.

In an example illustrated in FIG 6, a portion of the gas introducing pipe 50 from the upper end portion 51 to a predetermined position is located in the internal space 31 of the crucible 30 through the through hole 30a. The cooler 70 is integrated with the gas introducing pipe 50 in a manner similar to the first embodiment. Thus, a portion of the cooler 70 from the upper section 71 a to a predetermined position of the side section 71 c is also located in the internal space 31 of the crucible 30. Between the crucible 30 and the cooler 70 integrated with the gas introducing pipe 50, a clearance is provided so that the internal space 31 communicates with the low-temperature area of the vacuum chamber 10 located below the crucible 30.

The shielding plate 90 has the inverted L shape in cross section in a manner similar to the example illustrated in FIG 5. The short section 90a extends in the horizontal direction from the outer end portion 51 of the gas introducing pipe 50 to an outside of the cooler 70 so as to face the whole area of the upper section 71a of the body 71. The long section 90b extends in the vertical direction from a position upper than the cooler 70 to a position lower than the cooler 70 so as to face the whole area of the side section 71 c of the body 71. Thus, the whole are of the short section 90a and a portion of the long section 90b are located in the internal space 31 of the crucible 30. The shielding plate 90 is fixed, for example, by screwing in a state where the short section 90a is in contact with the upper end portion 51 of the gas introducing pipe 50 and a portion of the upper section 71 a. The shielding plate 90 is made of a material that can reflect the cooling water. A clearance is provided between the short section 90a and the other portion of the upper section 71 a and between the long section 90b and the side section 71c. The cooling water leaking from the cooler 70 can escape downward through the clearance.

In the apparatus 1 according to the present embodiment, a portion of the cooler 70 is located in the internal space 31 of the crucible 30. However, the scattering of the cooling water in the internal space 31 of the crucible 30 can be restricted by the shielding plate 90, and the cooling water can be dropped to the low-temperature area of the vacuum chamber 10 located below the crucible 30. Thus, a rapid pressure increase due to evaporation of the cooling water can be restricted.

The shielding plate 90 is provided to at least the portion of the cooler 70 facing the internal space 31 of the crucible 30. Thus, the lower end of the long section 90b is located at a height corresponding to the outer surface of the bottom of the crucible 30 or lower than the outer surface of the bottom. A configuration of the present apparatus 1 except for the shape of the shielding plate 90, the locations of the gas introducing pipe 50, the cooler 70, and the shielding plate 90 may be similar to the above-described configuration of the apparatus 1 according to the first embodiment.

### (Third Embodiment)

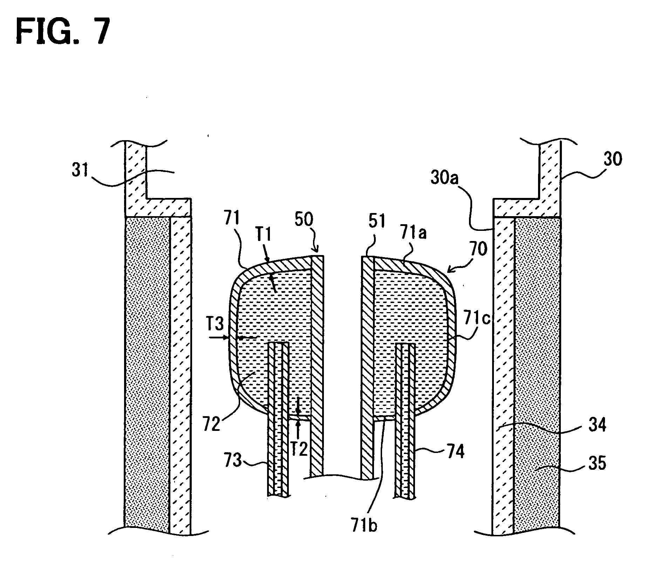

An apparatus for producing an SiC single crystal according to the present invention will be described with reference to FIG. 7. Because the apparatus 1 according to the present embodiment has many portions in common with the apparatus 1 according to the first embodiment, a description of the common portions will be omitted and different portions will be mainly described.

In the apparatuses 1 according to the first embodiment and the second embodiment, even if the cooling water leaks from the cooler 70, the cooling water is blocked by the shielding plate 90 so that the cooling water does not scatter in the internal space 31 of the crucible 30. In the apparatus 1 according to the present embodiment, the thickness of the body 71 of the cooler 70 is different by location so that even if the cooler 70 is damaged, the cooling water leaks from an opposite side of the internal space 31 of the crucible 30. In an example illustrated in FIG. 7, the shielding plate 90 is not provided.

In the example illustrated in FIG. 7, the gas introducing pipe 50 and the cooler 70 are located below the crucible 30. The body 71 of the cooler 70 has an approximately U-shape in cross section. The body 71 is made of SUS, for example. The upper end of the body 71 is joined at the upper end of the sidewall of the gas introducing pipe 50. The lower end of the body 71 is joined at a portion lower than the joint portion of the upper end of the body 71. The body 71 and the sidewall of the gas introducing pipe 50 define the storing space 72 through which the cooling water circulates. The cooler 70 has a ring shape surrounding the gas introducing pipe 50. The cooler 70 is coupled with the inlet pipe 73 and the outlet pipe 74. Each of the inlet pipe 73 and the outlet pipe 74 penetrate through the lower section 71 b of the body 71. The inlet pipe 73 supplies the cooling water from the outside of the vacuum chamber 10 to the storing space 72 of the cooler 70. The outlet pipe 74 drains the cooling water from the storing space 72 of the cooler 70 to the outside of the vacuum chamber 10.

The thickness of the upper section 71a of the body 71 facing the internal space 31 of the crucible 30 is defined as T1. The thickness of the lower section 71 b of the body 71 facing the bottom flange 16 is defined as T2. The thickness of the side section 71 c connecting the upper section 71 a and the lower section 71 b and facing the second heat insulating member 35 is defined as T3. In the example illustrated in FIG. 7, the thicknesses T1, T2, and T3 satisfy a relationship of T1>T3>T2. That is, the thickness T1 of the upper section 71a is the thickest and the thickness T2 of the lower section 71 b is the thinnest. Therefore, the upper section 71 a has the highest mechanical strength and the lower section 71 b has the lowest mechanical strength. The thickness of the gas introducing pipe 50 in the horizontal direction is greater than the thickness T1 of the upper section 71 a.

In the body 71 of the cooler 70, the lower section 71 b having the lowest mechanical strength is more likely to be damaged, and the upper section 71a having the highest mechanical strength is less likely to be damaged. Thus, even if the cooler 70 is damaged, the cooling water is less likely to scatter toward the internal space 31 of the crucible 30. Therefore, the scattering of the cooling water in the internal space 31 can be restricted and a rapid pressure increase in the vacuum chamber 10 due to evaporation of the cooling water can be restricted.

The thickness of the lower section 71 b is thinner than the thickness of the other section of the body 71. Even if the lower section 71 b is damaged, the cooling water does not scatter upward. Thus, a rapid pressure increase in the vacuum chamber 10 due to evaporation of the cooling water can be effectively restricted. However, the relationship among the thicknesses T1, T2, and T3 is not limited to T1>T3>T2. For example, the thicknesses T1, T2, and T3 may satisfy a relationship of T1≥T2>T2 or a relationship of T1>T3≥T2. At least the thickness of the lower section 71 b is thinnest in the body 71.

In the example illustrated in FIG. 7, the cooler 70 is located below the crucible 30. Alternatively, a portion of the cooler 70 may be located in the internal space 31 of the crucible 30. In such a case, a mechanical strength of a section of the body 71 facing the internal space 31 of the crucible 30, that is, a section of the body 71 above the outer surface of the bottom of the crucible 30 is set to be greater then a mechanical strength of the other section of the body 71. For example, in a case where the upper section 71a and a portion of the side section 71 c are located in the internal space 31 of the crucible 30, a thickness of a section of the body 71 located below the outer surface of the bottom of the crucible 30, at least, a thickness of the lower section 71 b is set to be thinner than the thickness of the section of the body 71 facing the internal space 31.

In the example illustrated in FIG. 7, the mechanical strength of the body 71 is varied by location by controlling the thickness. The difference in the mechanical strength may be provided by other way. For example, in a case where the body 71 is more likely to be damaged at a welded portion, the welded portion may be provided at a section of the body 71 other than the section facing the internal space 31 of the crucible 30.

A configuration of the present embodiment may be combined with the configuration of the first embodiment and/or the configuration of the second embodiment.

### (Other Embodiments)

Although the present invention has been fully described in connection with the third embodiment thereof with reference to the accompanying drawings, it is to be noted that various changes and modifications will become apparent to those skilled in the art.

In the above-described embodiments, cooling water is used as an example of the fluid circulating in the storing space 72. However, the fluid is not limited to cooling water.

In the above-described embodiments, the cooler 70 is disposed adjacent to the upper end portion 51 of the gas introducing pipe 50, as an example. However, the location of the cooler 70 with respect to the gas introducing pipe 50 is not limited to the above-described examples. At least the cooler 70 is required to be disposed adjacent to the gas introducing pipe 50 so that the cooler 70 is outside the supply passage of the source gas provided from the gas introducing pipe 50 to the SiC single crystal substrate 33 located above the gas introducing pipe 50.

A sensor for providing the leakage detecting element includes, but not limited to the temperature sensor 19. For example, a fluid level sensor for detecting a level of cooling water may be stored in the lower storing portion 21.

In the above-described embodiments, the leakage detecting element is provided by the temperature sensor 19 and the determining section of the controller 26. That is, the determining section is included in the controller 26. Alternatively, the temperature sensor 19 may include the determining section and the controller 26 may include only the control section.

In the above-described embodiments, the controller 26 has a control section that can function as the first control part for controlling the actuator of the supply control valve 75 provided at the inlet pipe 73, the second control part for controlling the actuator for controlling the outputs of the upper RF coil 24 and the lower RF coil 25, and the third control part for controlling the actuator for controlling the actuator of the pressure control valve 15 provided at the exhaust pipe 14. Alternatively, the first control part, the second control part, and the third control part may be provided separately.

## Claims

1. An apparatus (1) for producing a silicon carbide single crystal, comprising:
a vacuum chamber (10) defining an internal space;
a reaction container (30) disposed in the vacuum chamber (10), the reaction container (30) defining an internal space (31) where a silicon carbide single crystal substrate (33) is disposed as a seed crystal, the reaction container (30) having an opening portion (30a) through which the internal space (31) of the reaction container (30) communicates with a portion of the internal space of the vacuum chamber (10) located below the reaction container (30);
a gas introducing pipe (50) connecting an outside of the vacuum chamber (10) and an inside of the vacuum chamber (10) for supplying a mixed gas from the outside of the vacuum chamber (10) to the silicon carbide single crystal substrate (33) through the opening portion (30a) of the reaction container (30), the mixed gas including a silicon-including gas and a carbon-including gas; and
a cooler (70) disposed adjacent to the gas introducing pipe (50) and being apart from the reaction container (30), the cooler (70) being outside a supply passage of the mixed gas provided from the gas introducing pipe (50) to the silicon carbide single crystal substrate (33) located above the gas introducing pipe (50), the cooler (70) configured to reduce a surrounding temperature by fluid flowing in the cooler (70), wherein:
at least a portion of the cooler (70) is located below the reaction container (30);
the cooler (70) includes a wall (71) having a first section (71 a) facing the internal space (31) of the reaction container (30) and a second section (71 b) other than the first section;
the first section (71 a) has a first mechanical strength;
the second section (71 b) has a second mechanical strength; and
the first mechanical strength is greater than the second mechanical strength.

2. The apparatus (1) according to claim 1, wherein:
the first section (71 a) has a first thickness (T1):
the second section (71 b) has a second thickness (T2); and
the first thickness (T1) is greater than the second thickness (T2).

3. The apparatus (1) according to claim 1 or 2, further comprising:
an inlet pipe (73) connecting the outside of the vacuum chamber (10) and the inside of the vacuum chamber (10) for supplying the fluid from the vacuum chamber (10) to the cooler (70);
an outlet pipe (74) connecting the outside of the vacuum chamber (10) and the inside of the vacuum chamber (10) for draining the fluid from the cooler (70) to the outside of the vacuum chamber (10);
a supply control element (75) attached to the inlet pipe (73) for controlling an amount of the fluid to be supplied to the cooler (70);
a leakage detecting element (19) disposed in the portion of the internal space of the vacuum chamber (10) located below the reaction container (30) for detecting a leakage of the fluid from the cooler (70); and
a first control part (26) coupled with the supply control element (75) and the leakage detecting element (19), the first control part (26) configured to control the supply control element (75) so that the supply of the fluid is stopped when the leakage detecting element (19) detects a leakage of the fluid.

4. The apparatus (1) according to claim 3, wherein
the outlet pipe (74) is attached with a check valve (76).

5. The apparatus (1) according to claim 3 or 4, further comprising:
a heating element (24, 25) configured to heat the internal space (31) of the reaction container (30); and
a second control part (26) coupled with the heating element (24, 25), the second control part (26) configured to control the heating element (24, 25) so that an output of the heating element (24, 25) is reduced or stopped when the leakage detecting element (19) detects the leakage of the fluid.

6. The apparatus (1) according to any one of claims 3-5, further comprising:
an exhaust pipe (14) disposed above the reaction container (30) and connecting the outside of the vacuum chamber (10) and the inside of the vacuum chamber (10);
a pressure control element (15) attached to the exhaust pipe (14), the pressure control element (15) configured to control a pressure in the vacuum chamber (10) by changing an opening degree of the pressure control element (15); and
a third control part (26) coupled with the pressure control element (15), the third control part (26) configure to control the pressure control element (15) so that the opening degree of the pressure control element (15) becomes a fully open state when the leakage detecting element (19) detects the leakage of the fluid.

## Patentansprüche

1. Vorrichtung (1) zum Herstellen eines Siliziumkarbid-Einkristalls, die aufweist:
eine Vakuumkammer (10), die einen Innenraum definiert;
einen Reaktionsbehälter (30), der in der Vakuumkammer (10) angeordnet ist, wobei der Reaktionsbehälter (30) einen Innenraum (31) definiert, in dem ein Siliziumkarbid-Einkristallsubstrat (33) als ein Saatkristall angeordnet ist, wobei der Reaktionsbehälter (30) einen Öffnungsabschnitt (30a) aufweist, durch den der Innenraum (31) des Reaktionsbehälters (30) mit einem Abschnitt des Innenraums der Vakuumkammer (10), die unterhalb des Reaktionsbehälters (30) angeordnet ist, kommuniziert;
eine Gaseinleitungsleitung (50), die eine Außenseite der Vakuumkammer (10) und eine Innenseite der Vakuumkammer (10) zum Zuführen eines Mischgases von der Auβenseite der Vakuumkammer (10) zu dem Siliziumkarbid-Einkristallsubstrat (33) durch den Öffnungsabschnitt (30a) des Reaktionsbehälters (30) miteinander verbindet, wobei das Mischgas ein Gas, das Silizium enthält, und ein Gas, das Kohlenstoff enthält, enthält; und
eine Kühlvorrichtung (70), die benachbart zu der Gaseinleitungsleitung (50) angeordnet ist und von dem Reaktionsbehälter (30) getrennt ist, wobei die Kühlvorrichtung (70) außerhalb einer Zufuhrpassage des Mischgases, das von der Gaseinleitungsleitung (50) dem Siliziumkarbid-Einkristallssubstrat (33), das oberhalb der Gaseinleitungsleitung (50) angeordnet ist, bereitgestellt wird, liegt, wobei die Kühlvorrichtung (70) ausgelegt ist, eine Umgebungstemperatur durch einen Fluidfluss in der Kühlvorrichtung (70) zu verringern, wobei
mindestens ein Abschnitt der Kühlvorrichtung (70) unterhalb des Reaktionsbehälters (30) angeordnet ist;
die Kühlvorrichtung (70) eine Wand (71) enthält, die einen ersten Abschnitt (71 a), der zu dem Innenraum (31) des Reaktionsbehälters (30) zeigt, und einen zweiten Abschnitt (71), der ein anderer als der erste Abschnitt ist, aufweist;
der erste Abschnitt (71a) eine erste mechanische Festigkeit aufweist;
der zweite Abschnitt (71 b) eine zweite mechanische Festigkeit aufweist; und
die erste mechanische Festigkeit größer als die zweite mechanische Festigkeit ist.

2. Vorrichtung (1) nach Anspruch 1, wobei
der erste Abschnitt (71 a) eine erste Dicke (T1) aufweist;
der zweite Abschnitt (71 b) eine zweite Dicke (T2) aufweist; und
die erste Dicke (T1) größer als die zweite Dicke (T2) ist.

3. Vorrichtung (1) nach Anspruch 1 oder 2, die außerdem aufweist:
eine Einlassleitung (73), die die Außenseite der Vakuumkammer (10) und die Innenseite der Vakuumkammer (10) zum Zuführen des Fluids von der Vakuumkammer (10) zu der Kühlvorrichtung (70) miteinander verbindet;
eine Auslassleitung (74), die die Außenseite der Vakuumkammer (10) und die Innenseite der Vakuumkammer (10) zum Abziehen des Fluids von der Kühlvorrichtung (70) zu der Außenseite der Vakuumkammer (10) miteinander verbindet;
ein Zufuhrsteuerelement (75), das an der Einlassleitung (73) zum Steuern einer Menge des Fluids, die der Kühlvorrichtung (70) zuzuführen ist, befestigt ist;
ein Leckerfassungselement (19), das in dem Abschnitt des Innenraums der Vakuumkammer (10), der unterhalb des Reaktionsbehälters (70) angeordnet ist, zum Erfassen eines Leckens des Fluids aus der Kühlvorrichtung (70) angeordnet ist; und
einen ersten Steuerteil (26), der mit dem Zufuhrsteuerelement (75) und dem Leckerfassungselement (19) gekoppelt ist, wobei der erste Steuerteil (26) ausgelegt ist, das Zufuhrsteuerelement (75) zu steuern, sodass die Zufuhr des Fluids gestoppt wird, wenn das Leckerfassungselement (19) ein Lecken des Fluids erfasst.

4. Vorrichtung (1) nach Anspruch 3, wobei die Auslassleitung (74) mit einem Rückschlagventil (76) befestigt ist.

5. Vorrichtung (1) nach Anspruch 3 oder 4, die außerdem aufweist:
ein Heizelement (24, 25), das ausgelegt ist, den Innenraum (31) des Reaktionsbehälters (30) zu heizen; und
einen zweiten Steuerteil (26), der mit dem Heizelement (24, 25) gekoppelt ist, wobei der zweite Steuerteil (26) ausgelegt ist, das Heizelement (24, 25) zu steuern, sodass ein Ausgang des Heizelementes (24, 25) verringert oder gestoppt wird, wenn das Leckerfassungselement (19) das Lecken des Fluids erfasst.

6. Vorrichtung (1) nach einem der Ansprüche 3 bis 5, die außerdem aufweist:
eine Auslassleitung (14), die oberhalb des Reaktionsbehälters (30) angeordnet ist und die Außenseite der Vakuumkammer (10) und die Innenseite der Vakuumkammer (10) miteinander verbindet;
ein Drucksteuerelement (15), das an der Auslassleitung (14) befestigt ist, wobei das Drucksteuerelement (15) ausgelegt ist, einen Druck in der Vakuumkammer (10) durch Ändern eines Öffnungsgrads des Drucksteuerelementes (15) zu steuern; und
einen dritten Steuerteil (26), der mit dem Drucksteuerelement (15) gekoppelt ist, wobei der dritte Steuerteil (26) ausgelegt ist, das Drucksteuerelement (15) zu steuern, sodass der Öffnungsgrad des Drucksteuerelementes (15) einen vollständig geöffneten Zustand annimmt, wenn das Leckerfassungselement (19) das Lecken des Fluids erfasst.

## Revendications

1. Appareil (1) de production d'un monocristal de carbure de silicium, comprenant :
une chambre à vide (10) définissant un espace intérieur ;
une cuve de réaction (30) logée dans ladite chambre à vide (10), ladite cuve de réaction (30) définissant un espace intérieur (31) dans lequel un substrat (33) de monocristal de carbure de silicium est disposé en tant que germe d'inoculation, la cuve de réaction (30) comportant une zone d'ouverture (30a) par l'intermédiaire de laquelle l'espace intérieur (31) de ladite cuve de réaction (30) communique avec une partie de l'espace intérieur de la chambre à vide (10) située au-dessous de ladite cuve de réaction (30);
une tubulure (50) d'introduction de gaz, raccordant une région extérieure de la chambre à vide (10) à une région intérieure de ladite chambre à vide (10), de manière à délivrer un mélange gazeux au substrat (33) de monocristal de carbure de silicium depuis l'extérieur de ladite chambre à vide (10), par l'intermédiaire de la zone d'ouverture (30a) de la cuve de réaction (30), ledit mélange gazeux incluant un gaz renfermant du silicium et un gaz renfermant du carbone ; et
un refroidisseur (70) occupant une position adjacente à la tubulure (50) d'introduction de gaz et implanté distinctement de la cuve de réaction (30), ledit refroidisseur (70) étant situé à l'extérieur d'un passage de délivrance du mélange gazeux, partant de la tubulure (50) d'introduction de gaz et gagnant le substrat (33) de monocristal de carbure de silicium placé au-dessus de ladite tubulure (50) d'introduction de gaz, le refroidisseur (70) étant agencé en vue de diminuer une température ambiante sous l'action d'un fluide en circulation dans ledit refroidisseur (70),
dans lequel :
au moins une partie du refroidisseur (70) est située au-dessous de la cuve de réaction (30) ;
ledit refroidisseur (70) est pourvu d'une paroi (71) comprenant un premier tronçon (71a) pointant vers l'espace intérieur (31) de la cuve de réaction (30), et un second tronçon (71b) différent dudit premier tronçon ;
le premier tronçon (71a) présente une première résistance mécanique ;
le second tronçon (71b) présente une seconde résistance mécanique ; et
la première résistance mécanique est supérieure à la seconde résistance mécanique.

2. Appareil (1) selon la revendication 1, dans lequel :
le premier tronçon (71a) présente une première épaisseur (T1) ;
le second tronçon (71 b) présente une seconde épaisseur (T2) ; et
la première épaisseur (T1) est supérieure à la seconde épaisseur (T2).

3. Appareil (1) selon la revendication 1 ou 2, comprenant en outre :
une tubulure d'admission (73) raccordant l'extérieur de la chambre à vide (10) à l'intérieur de ladite chambre à vide (10), afin de délivrer le fluide au refroidisseur (70) à partir de ladite chambre à vide (10) ;
une tubulure de sortie (74) raccordant l'extérieur de la chambre à vide (10) à l'intérieur de ladite chambre à vide (10), afin d'évacuer le fluide depuis ledit refroidisseur (70) vers l'extérieur de ladite chambre à vide (10) ;
une élément (75) de commande de l'alimentation, relié à ladite tubulure d'admission (73) afin de commander une quantité dudit fluide devant être délivrée audit refroidisseur (70) ;
un élément (19) détecteur de fuites, disposé dans la partie de l'espace intérieur de la chambre à vide (10) située au-dessous de la cuve de réaction (30), en vue de détecter une fuite dudit fluide à partir dudit refroidisseur (70) ; et
une première partie de commande (26) reliée audit élément (75) de commande de l'alimentation et audit élément (19) détecteur de fuites, ladite première partie de commande (26) étant agencée pour piloter ledit élément (75) de commande de l'alimentation de façon telle que la délivrance du fluide soit interrompue lorsque ledit élément (19), détecteur de fuites, détecte une fuite du fluide.

4. Appareil (1) selon la revendication 3, dans lequel :
la tubulure de sortie (74) est associée à un clapet antiretour (76).

5. Appareil (1) selon la revendication 3 ou 4, comprenant en outre :
un élément chauffant (24, 25) agencé pour chauffer l'espace intérieur (31) de la cuve de réaction (30) ; et
une deuxième partie de commande (26) reliée audit élément chauffant (24, 25), ladite deuxième partie de commande (26) étant agencée pour piloter l'élément chauffant (24, 25) de façon telle qu'une puissance de sortie, fournie par ledit élément chauffant (24, 25), soit réduite ou interrompue lorsque l'élément (19), détecteur de fuites, détecte la fuite du fluide.

6. Appareil (1) selon l'une quelconque des revendications 3-5, comprenant en outre :
une tubulure d'évacuation (14), disposée au-dessus de la cuve de réaction (30) et raccordant l'extérieur de la chambre à vide (10) à l'intérieur de ladite chambre à vide (10) ;
un élément (15) de commande de pression, associé à ladite tubulure d'évacuation (14), ledit élément (15) de commande de pression étant agencé afin de commander une pression régnant dans la chambre à vide (10), en faisant varier un degré d'ouverture dudit élément (15) de commande de pression ; et
une troisième partie de commande (26) reliée à l'élément (15) de commande de pression, ladite troisième partie de commande (26) étant agencée pour piloter l'élément (15) de commande de pression de façon telle que le degré d'ouverture dudit élément (15) de commande de pression devienne un état d'ouverture intégrale lorsque l'élément (19), détecteur de fuites, détecte la fuite du fluide.
